# EUROPÄISCHE PATENTSCHRIFT

(11) **EP 3 805 643 B1**
(45) Veröffentlichungstag und Bekanntmachung des Hinweises auf die Patenterteilung: **26.02.2025**
(21) Anmeldenummer: 20197454.0
(22) Anmeldetag: 22.09.2020
(51) Int. Cl.: F24C 7/08, H03K 17/96, H03K 17/98, H03K 17/975

(54) **BEDIENVORRICHTUNG FÜR EIN HAUSHALTSGERÄT ZUR BERÜHRUNGSBASIERTEN UND ZUR BERÜHRUNGSLOSEN KAPAZITÄTSÄNDERUNGSERFASSUNG, HAUSHALTSGERÄT SOWIE VERFAHREN**
CONTROL DEVICE FOR A HOUSEHOLD APPLIANCE FOR CONTACT-BASED AND NON-CONTACT CAPACITY CHANGE DETECTION, DOMESTIC APPLIANCE AND METHOD
DISPOSITIF DE COMMANDE POUR UN APPAREIL ÉLECTROMÉNAGER DESTINÉ À LA DÉTECTION TACTILE ET SANS CONTACT DU CHANGEMENT DE CAPACITÉ, APPAREIL ÉLECTROMÉNAGER AINSI QUE PROCÉDÉ

(30) Priorität: 09.10.2019 DE 102019215463
(43) Veröffentlichungstag der Anmeldung: 14.04.2021
(73) Patentinhaber: BSH Hausgeräte GmbH, 81739 München (DE)
(72) Erfinder: Alt, René, 83624 Otterfing (DE); Beliveau, Thomas Eric, 80798 München (DE); Grobleben, Ralf, 75015 Bretten (DE); Leinmüller, Elena, 85521 Ottobrunn (DE); Methner, Lukas, 82544 Egling (DE); Popp, Torsten, 85276 Pfaffenhofen (DE); Schönfuss, Katja, 81677 München (DE); Schmidt, Tobias, 81371 München (DE); Schumacher, Frank, 80337 München (DE); Harrer, Sabine, 85129 Oberdolling (DE); Lernbecher, Martin, 93359 Wildenberg (DE); Reinker, Bernward Maria, 93128 Regenstauf (DE); Makhtyuk, Roman, 93087 Alteglofsheim (DE); Stanov, Arthur, 67550 Ibersheim (DE)

(56) Entgegenhaltungen:
- DE-A1- 102014 200 888
- DE-A1- 102014 223 371
- US-A1- 2018 217 690

## Beschreibung

Die Erfindung betrifft eine Bedienvorrichtung für ein Haushaltsgerät mit einer Bedienoberfläche, welche dazu ausgebildet ist, bei Bedienung durch einen Nutzer der Bedienvorrichtung zumindest eine Betriebsbedingung des Haushaltsgeräts einzustellen, wobei auf einer Unterseite der Bedienoberfläche eine kapazitive Erfassungseinrichtung zum kapazitiven Erfassen der Bedienung ausgebildet ist, wobei die Unterseite gegenüber einer Oberseite, welche bei Bedienung dem Nutzer zugewandt ist und eine Außenseite der Bedienvorrichtung bildet, ausgebildet ist. Ferner betrifft die Erfindung ein Haushaltsgerät mit einer Bedienvorrichtung sowie ein Verfahren zum Bedienen einer Bedienvorrichtung.

Aus dem Stand der Technik ist bereits hinlänglich eine Vielzahl von Bedienvorrichtungen zum Bedienen eines Haushaltsgeräts bekannt. Insbesondere sind hierzu unterschiedliche berührungssensitive Bedienvorrichtungen bekannt, welche in einer Bedienblende eingesetzt werden können. Entsprechende Erfassungseinrichtungen zum Erfassen der Berührung befinden sich insbesondere auf einer Elektronik der Bedienvorrichtung. Ferner sind bereits abnehmbare Bedienelemente bei insbesondere Mulden als Haushaltsgeräten, beispielsweise ein sogenanntes "twist pad", bekannt.

Der in DE 10 2014 223371 A1, DE 10 2014 200888 A1 und US 2018/217690 A1 offenbarte Stand der Technik ist für die vorliegende Erfindung relevant.

Aufgabe der vorliegenden Erfindung ist es, eine Bedienvorrichtung, ein Haushaltsgerät sowie ein Verfahren zu schaffen, mittels welchen hochfunktional ein Haushaltsgerät bedient werden kann.

Diese Aufgabe wird durch eine Bedienvorrichtung, ein Haushaltsgerät sowie durch ein Verfahren gemäß den unabhängigen Patentansprüchen gelöst. Vorteilhafte Ausgestaltungsformen sind in den Unteransprüchen angegeben.

Ein Aspekt der Erfindung betrifft eine Bedienvorrichtung für ein Haushaltsgerät mit einer Bedienoberfläche, welche dazu ausgebildet ist, bei Bedienung durch einen Nutzer der Bedienvorrichtung zumindest eine Betriebsbedingung des Haushaltsgeräts einzustellen, wobei auf einer Unterseite der Bedienoberfläche eine kapazitive Erfassungseinrichtung zum kapazitiven Erfassen der Bedienung ausgebildet ist, wobei die Unterseite gegenüber einer Oberseite, welche bei Bedienung dem Nutzer zugewandt ist und eine Außenseite der Bedienvorrichtung bildet, ausgebildet ist.

Es ist vorgesehen, dass die Erfassungseinrichtung als berührungssensitive Erfassungseinrichtung ausgebildet ist und dazu ausgebildet ist, die Bedienung des Nutzers durch eine Berührung der Oberseite durch den Nutzer auf Basis einer berührungsbasierten Kapazitätsänderung zu erfassen und zusätzlich dazu ausgebildet ist, die Bedienung des Nutzers durch ein von dem Nutzer bedientes Bedienelement der Bedienvorrichtung auf der Bedienoberfläche auf Basis einer berührungslosen Kapazitätsänderung durch das Bedienelement zu erfassen.

Dadurch ist es ermöglicht, dass somit auf zwei unterschiedliche Arten eine Bedienung erfolgen kann. Insbesondere durch beispielsweise einen Finger des Nutzers, kann eine Bedienung auf der berührungssensitiven Erfassungseinrichtung berührungsbasiert durchgeführt werden. Alternativ oder ergänzend kann mittels eines Bedienelements, welches auf der Bedienoberfläche angeordnet werden kann, eine entsprechende Bedienung erfolgen. Dadurch ist es ermöglicht, dass hochfunktionell die Bedienvorrichtung durch den Nutzer bedient werden kann. Insbesondere kann damit der Benutzer personalisiert entscheiden, ob dieser berührungsbasiert oder berührungslos mit dem Bedienelement das Haushaltsgerät bedienen möchte.

Insbesondere wird dadurch der Aufbau einer robusten Bedienvorrichtung für die Verwendung in einem Haushaltsgerät bei der Verwendung/Auswertung von kapazitiven Erfassungseinrichtungen, welche auch als Touch-Sensoren bezeichnet werden können, erreicht, bei welcher ein stabiler und definierter mechanischer Aufbau notwendig ist, da die Touch-Sensorik empfindlich auf Material- und/oder Abstandstoleranzen zwischen dem Sensor und dem Finger reagiert. Des Weiteren werden dadurch mechanische Toleranzen zwischen dem Sensor und dem Finger minimiert. Ferner kann dadurch variantenreduziert eine entsprechende Bedienvorrichtung bereitgestellt werden. Insbesondere kann hierbei ein Blendendesign, beispielsweise eine Schalterfront des Haushaltsgeräts, das eine marken- und produktspezifische Ausprägung der Bedienvorrichtung, welche auch als User Interface bezeichnet werden, kann beziehungsweise der Bedienblende aufweist, ohne aufwendige Hardware-Änderungen ermöglicht werden. Ferner kann insbesondere vorgesehen sein, dass die Bedienelemente sowohl auf der Bedienoberfläche, insbesondere sozusagen "on-screen", angeordnet sind, das heißt, die Bedienung erfolgt über beziehungsweise auf dem Display beziehungsweise auch außerhalb des Displays, sozusagen "off-screen" - das heißt Einzeltasten und Slider sind neben dem Display. Insbesondere ist somit vorgesehen, dass die Bedienoberfläche auch eine Anzeigeeinrichtung aufweisen kann, auf welcher entsprechende Symbole beziehungsweise Eingabemöglichkeiten angezeigt werden können.

Als Bedienelement können insbesondere mechanische Bedienelemente, wie zum Beispiel ein "rotary encoder", ein Programmwähler oder Tastenelemente, gewählt werden, welche insbesondere keine elektrischen Durchbrüche aufweisen. Dadurch kann eine hohe Flexibilität sowie eine hohe elektrische Robustheit, insbesondere gegenüber EMV (elektromagnetische Verträglichkeit), realisiert werden. Des Weiteren sind die Bedienelemente entsprechend reinigungsfreundlich und verschleißfrei.

Bevorzugt ist die Bedienoberfläche aus Glas oder aus Polymethylmethacrylat. Das Polymethylmethacrylat kann auch als PMMA bezeichnet werden. Insbesondere handelt es sich dabei um einfach zu verarbeitende Bedienoberflächen. Insbesondere können diese leicht hergestellt werden, und eine leichte Bedienung durch den Nutzer ist ermöglicht. Ferner ist beispielsweise eine leichte Reinigung durch den Nutzer ermöglicht.

Ferner kann bevorzugt vorgesehen sein, dass die Bedienvorrichtung einen Mikrocontroller aufweist, welcher dazu ausgebildet ist, in Abhängigkeit von der erfassten Kapazitätsänderung ein Steuersignal zum Einstellen der Betriebsbedingung zu erzeugen. Bei dem Mikrocontroller kann es sich beispielsweise um eine sogenannte "Mikro C Logik" handeln. Hierzu können unterschiedliche Schaltkreise und Elektronikbausteine innerhalb des Mikrocontrollers ausgebildet sein, um eine entsprechende Auswertung und Erzeugung des Steuersignals vornehmen zu können.

Vorzugsweise ist der Mikrocontroller dazu ausgebildet, bei einem Überschreiten des vorgegebenen Kapazitätsänderungsschwellwerts der erfassten Kapazitätsänderung das Steuersignal zu erzeugen. Mit anderen Worten werden das Steuersignal und die Einstellung der Betriebsbedingung erst dann durchgeführt, wenn der Kapazitätsänderungsschwellwert überschritten ist. Dadurch ist es ermöglicht, dass beispielsweise bei einer ungewollten Berührung der Bedienoberfläche eine Bedienung erfolgt. Dadurch ist eine zuverlässige Bedienung der Bedienvorrichtung ermöglicht.

Weiterhin bevorzugt ist die Bedienoberfläche durchbruchslos ausgebildet. Mit anderen Worten ist vorgesehen, dass die Bedienoberfläche keine Durchbrüche und Löcher aufweist. Dadurch kann insbesondere die Elektronik, insbesondere ein Foliensensor, besser vor Umwelteinflüssen geschützt werden. Des Weiteren ist die Elektronik besser vor einem ESD (Electro-Static-Discharge) geschützt und weist damit auch eine elektrische Robustheit, insbesondere gegenüber einer elektromagnetischen Verträglichkeit auf. Ferner können elektrische Luft- und Kriechstrecken vermieden werden, wodurch ebenfalls die Bedienvorrichtung verbessert gegen ESD geschützt ist. Ferner ist die Bedienoberfläche dadurch reinigungsfreundlicher für den Nutzer.

Erfindungsgemäß ist die kapazitive Erfassungseinrichtung als Foliensensor ausgebildet. Insbesondere handelt es sich bei dem Foliensensor um einen sogenannten zweidimensionalen Foliensensor. Bei dem Foliensensor handelt es sich insbesondere um einen einstückigen Foliensensor. Insbesondere ist der Foliensensor somit direkt hinter der Bedienoberfläche angeordnet. Der Foliensensor wird insbesondere auf die Bedienoberfläche aufgeklebt, das heißt, der Sensor wird fest mit der Bedienoberfläche verbunden. Der Foliensensor hat insbesondere den Vorteil, dass dieser beispielsweise mit einem Rolle-zu-Rolle-Verfahren (R2R-Verfahren) hergestellt werden kann. Insbesondere ist der Foliensensor dazu ausgebildet, sowohl die Position als auch die Stellung von einem mechanischen Bedienelement, beispielsweise von einem Inkremental-Geber oder Programmwähler, auszuwerten als auch die Bedienung mit dem menschlichen Finger selbst durchzuführen. Somit ist der Foliensensor insbesondere als berührungssensitiver Foliensensor ausgebildet.

Erfindungsgemäß weist der Foliensensor eine diamantartige Struktur von Erfassungselementen der kapazitiven Erfassungseinrichtung auf, insbesondere weist somit der Foliensensor ein sogenanntes Diamant-Pattern auf. Mittels des Diamant-Patterns ist insbesondere eine Erfassung einer Selbstkapazität sowie einer Gegenkapazität ermöglicht. Insbesondere wird durch ein Diamant-Pattern eine sogenannte Mehrfingergestenerkennung, welche auch als "Multi-Touch"-Fähigkeit bezeichnet werden kann, ermöglicht. Ferner ermöglicht dies die gleichzeitige Auswertung verschiedener Eingaben. Dadurch ist es ermöglicht, dass einfach und dennoch zuverlässig hochfunktionell eine Bedienung durch den Nutzer erfasst werden kann.

Ferner hat es sich als vorteilhaft erwiesen, wenn der Foliensensor eine Vielzahl von nebeneinander liegenden Erfassungselementen aufweist, welche mittels der kapazitiven Erfassungseinrichtung unabhängig voneinander ausgewertet sind. Insbesondere kann dadurch eine Art Backgammon-Struktur des Sensors bereitgestellt werden. Insbesondere weisen somit die Erfassungselemente eine Struktur auf, welche einem Backgammon-Brett entspricht. Insbesondere weisen diese Erfassungselemente eine entsprechende Backgammon-Geometrie auf. Dadurch ist es ermöglicht, dass eine einfache Eigenkapazitätsmessung durchgeführt werden kann. Insbesondere kann geometrieabhängig die Backgammon-Struktur beziehungsweise die Vielzahl von nebeneinander liegenden Erfassungselementen in sogenannte logische Bereiche unterteilt werden, so dass diese unabhängig voneinander ausgewertet werden können. Dadurch ist eine einfache und dennoch zuverlässige Erfassung der Bedienung durch den Nutzer ermöglicht.

Erfindungsgemäß ist die berührungssensitive Erfassungseinrichtung als berührungssensitive Anzeigeeinrichtung ausgebildet und ist die berührungssensitive Erfassungseinrichtung zum Anzeigen zumindest eines Symbols und zum Erfassen der Berührung ausgebildet.

Mit anderen Worten kann die kapazitive Erfassungseinrichtung beziehungsweise die berührungssensitive Erfassungseinrichtung als Touchscreen bereitgestellt werden. Mit anderen Worten können sowohl die Anzeige von Symbolen als auch die Berührungserfassung mit der berührungssensitiven Anzeigeeinrichtung durchgeführt werden. Beispielsweise kann durch Berühren des entsprechenden Symbols durch den Nutzer die entsprechende Betriebsbedingung eingestellt werden.

Bevorzugt kann vorgesehen sein, dass der Foliensensor größer ausgebildet ist als die berührungssensitive Anzeigeeinrichtung, mit anderen Worten als der berührungssensitive Touchscreen. Insbesondere ist es dadurch ermöglicht, dass beispielsweise neben dem berührungssensitiven Anzeigebereich (off-screen) noch ein weiterer Bereich angeordnet ist, auf welchen das Bedienelement beispielsweise zur Bedienung angeordnet werden kann, ohne dabei die Sicht auf den Touchscreen (on-screen) zu beeinträchtigen.

Insbesondere kann somit eine Überlappung eines Bedienbereichs mit dem Bedienelement und mit dem Touchscreen realisiert werden. Dadurch ist eine hochfunktionale Bedienvorrichtung realisiert.

Erfindungsgemäß ist das Bedienelement dazu ausgebildet, zerstörungsfrei auf der Bedienoberfläche aufgesetzt und abgenommen zu werden. Insbesondere ist dadurch gegeben, dass das Bedienelement nicht fest mit der Bedienvorrichtung verbunden ist, sondern abgenommen werden kann. Sollte es dabei zu einem Defekt des Bedienelements kommen, so kann dieses einfach ausgetauscht werden. Beispielsweise kann es sich bei einem solchen Bedienelement um ein sogenanntes "Twist-Pad" handeln. Hierzu kann beispielsweise das Bedienelement mechanisch an der Bedienoberfläche verrastet und dennoch wieder abnehmbar sein. Beispielsweise kann das Bedienelement hierzu Elektroden, beispielsweise Metallflächen aufweisen, welche nahe der Bedienoberfläche angeordnet sind, so dass diese mit der berührbaren Bedienoberfläche verbunden sind, so dass eine Einzelelektrode beispielsweise im Selbstkapazitätsmodus oder das Elektroden-Pattern in einem Gegenkapazitätsmodus, wodurch beispielsweise auch eine Multi-Touch-Fähigkeit bereitgestellt wird, bei Berührung/Bedienung des Bedienelements auf dem Touch-Sensor ein entsprechendes Intensitätspattern erzeugt, das von beispielsweise einem Mikrocontroller ausgewertet und in eine Bedienoperation, insbesondere in das Einstellen der Betriebsbedingung, umgesetzt wird.

Alternativ oder zusätzlich dazu kann das Bedienelement dazu ausgebildet sein, frei beweglich auf der Bedienoberfläche verschoben zu werden. Dadurch ist insbesondere eine individuelle Bedienung durch den Nutzer ermöglicht. Der Nutzer kann auf der Bedienoberfläche das Bedienelement frei verschieben und selbst wählen, an welcher Stelle eine entsprechende Bedienung durchgeführt werden kann. Durch die Foliensensorausgestaltung ist es insbesondere ermöglicht, dass die Bedienoberfläche relativ groß ausgestaltet werden kann, so dass durch den Nutzer an unterschiedlichen Stellen eine Bedienung der Bedienvorrichtung realisiert ist.

In einer weiteren vorteilhaften Ausgestaltungsform ist das Bedienelement magnetisch ausgebildet, und das Bedienelement ist mittels einer Magneteinrichtung der Bedienvorrichtung an der Bedienoberfläche gehalten. Mit anderen Worten kann eine magnetische Fixierung des Bedienelements an der Bedienoberfläche durchgeführt werden. Hierzu kann sowohl das Bedienelement als auch die Bedienoberfläche entsprechende magnetische Elemente aufweisen, so dass eine entsprechende Fixierung ermöglicht ist. Dadurch ist insbesondere ein zerstörungsfreies Anbringen und Abnehmen des Bedienelements ermöglicht. Ferner kann durch die Magneteinrichtung eine freie Beweglichkeit des Bedienelements gegenüber der Bedienoberfläche realisiert werden. Insbesondere kann zusätzlich ein Herunterfallen des Bedienelements, beispielsweise bei einer vertikalen Ausrichtung der Bedienvorrichtung im bestimmungsgemäßen Gebrauch, verhindert werden.

Erfindungsgemäß ist die kapazitive Erfassungseinrichtung dazu ausgebildet, eine Eigenkapazität und/oder eine Gegenkapazität zum Erfassen der Kapazitätsänderung zu erfassen. Mit anderen Worten ist die kapazitive Erfassungseinrichtung sowohl "self-capacitance"-fähig als auch "mutual-capacitance"-fähig. Dadurch ist es auf unterschiedliche Arten und Weisen ermöglicht, eine Bedienung der Bedienvorrichtung zu realisieren. Insbesondere ist es dadurch ermöglicht, dass zuverlässig eine Bedienung sowohl durch Berührung als auch berührungslos erfolgen kann. Insbesondere in der Gegenkapazitätserfassung lassen sich komplexe Bedienelemente realisieren. Insbesondere können dadurch mit dem einen Bedienelement unterschiedliche Funktionen innerhalb der Bedienvorrichtung beziehungsweise innerhalb des Haushaltsgeräts bedient werden. Eine elektrische Funktionalität des Bedienelements ist dadurch insbesondere vor mechanischen Einflüssen weitgehend entkoppelt.

In einer weiteren vorteilhaften Ausgestaltungsform ist die kapazitive Erfassungseinrichtung zum Erfassen einer relativen Position des Bedienelements und in Abhängigkeit von der erfassten Position ist die zumindest eine Betriebsbedingung eingestellt. Mit anderen Worten kann in Abhängigkeit der Position relativ zu der Bedienoberfläche die Betriebsbedingung eingestellt werden. Beispielsweise kann vorgesehen sein, sollte sich das Bedienelement auf einer ersten Seite der Bedienoberfläche befinden, beispielsweise auf einer linken Seite der Bedienoberfläche, so kann eine erste Betriebsbedingung eingestellt werden. Sollte sich das Bedienelement auf einer zweiten Seite der Bedienoberfläche, beispielsweise auf einer rechten Seite der Bedienoberfläche, befinden, so kann eine zweite Betriebsbedingung eingestellt werden.

Insbesondere kann somit im Gegenkapazitätsmodus das von der Erfassungseinrichtung gemessene Intensitätspattern abhängig von Größe und Form der jeweiligen Elektroden innerhalb des Bedienelements parallel zur Bedienoberfläche realisiert werden, wodurch sich die absolute Position, insbesondere die absolute Winkelposition, des Bedienelements feststellen lässt. In Abhängigkeit davon kann dann, wie bereits erwähnt, die Betriebsbedingung eingestellt werden.

Alternativ oder zusätzlich hat es sich als vorteilhaft erwiesen, wenn die kapazitive Erfassungseinrichtung zum Erfassen einer relativen Stellung des Bedienelements gegenüber der Bedienoberfläche ausgebildet ist und in Abhängigkeit der erfassten Stellung die zumindest eine Betriebsbedingung eingestellt ist. Beispielsweise kann hierzu im Gegenkapazitätsmodus die Erfassungseinrichtung in Abhängigkeit der gemessenen Intensitätspattern abhängig vom Abstand der Elektroden zur Bedienoberfläche eine entsprechende Kapazitätsänderung erfassen, insbesondere lassen sich dadurch die Abstandsänderungen, wie bei einer Tastenbetätigung, beispielsweise einem "Tactile Switch", durchführen. Durch die Abstandsänderung zur Bedienoberfläche kann beispielsweise auch ein Twist-Pad benutzt werden. Dadurch kann bei beispielsweise einem Kippen des Twist-Pads gegenüber der Bedienoberfläche eine entsprechende Betriebsbedingung eingestellt werden. Dadurch ist es hochfunktionell ermöglicht, unterschiedliche Bedienelemente einzusetzen und dabei hochfunktionell die unterschiedlichen Betriebsbedingungen des Haushaltsgeräts einzustellen.

Erfindungsgemäß ist die kapazitive Erfassungseinrichtung zum Erfassen einer Mehrfingergestensteuerung ausgebildet. Insbesondere ist dadurch ermöglicht, dass beispielsweise auf unterschiedliche Gesten mit dem Finger unterschiedliche Betriebsbedingungen des Haushaltsgeräts eingestellt werden können. Beispielsweise kann durch Berührung mit zwei Fingern eine erste Betriebsbedingung eingestellt werden, während mit einer Berührung nur mit einem Finger eine weitere Betriebsbedingung eingestellt werden kann. Ferner kann beispielsweise vorgesehen sein, dass durch eine "Heraus-Zoom-Bewegung" ein Auswählen eines übergeordneten Menüs der Bedienvorrichtung realisiert werden kann. Durch ein "Herein-Zoomen" kann wiederum in ein Untermenü gegangen werden.

In einer weiteren vorteilhaften Ausgestaltungsform weist das Bedienelement eine Vielzahl von Elektroden auf, welche mit der kapazitiven Erfassungseinrichtung wechselwirkt und auf Basis dieser Wechselwirkung die berührungslose Bedienung erfasst ist. Insbesondere können somit sowohl die Position des Bedienelements als auch die Stellung des Bedienelements ausgewertet werden. Durch die Vielzahl an Elektroden, welche beispielsweise ringförmig innerhalb des Bedienelements angeordnet werden können, kann somit eine Vielzahl von unterschiedlichen Einstellungen vorgenommen werden, die wiederum eine Vielzahl von unterschiedlichen Betriebsbedingungen am Haushaltsgerät einstellen können. Somit können mittels des einen Bedienelements eine Vielzahl von unterschiedlichen Betriebsbedingungen eingestellt werden. Dadurch ist hochfunktionell die Bedienvorrichtung durch den Nutzer bedienbar.

Gemäß einer weiteren vorteilhaften Ausgestaltungsform ist die kapazitive Erfassungseinrichtung zum gleichzeitigen Erfassen der berührungsbasierten Kapazitätsänderung und der berührungslosen Kapazitätsänderung ausgebildet. Mit anderen Worten kann vorgesehen sein, dass der Nutzer sowohl mit dem Finger die Bedienoberfläche berührt und eine Betriebsbedingung einstellt und gleichzeitig mit dem Bedienelement eine entsprechende weitere Betriebsbedingung einstellt beziehungsweise die Betriebsbedingung sowohl mittels der Berührung als auch mittels des Bedienelements einstellen kann. Dadurch kann hochfunktionell und benutzerfreundlich die Bedienvorrichtung bereitgestellt werden.

Ein weiterer Aspekt der Erfindung betrifft ein Haushaltsgerät mit einer Bedienvorrichtung, wobei das Haushaltsgerät insbesondere ein Gargerät nach dem vorhergehenden Aspekt. Beispielsweise kann das Gargerät als Backofen oder Kochmulde ausgebildet sein.

Ferner hat es sich als vorteilhaft erwiesen, wenn die Bedienoberfläche bei einem bestimmungsgemäßen Gebrauch des Haushaltsgeräts horizontal und/oder vertikal an dem Haushaltsgerät angeordnet ist. Mit anderen Worten kann die Bedienvorrichtung sowohl horizontal als auch vertikal an dem Haushaltsgerät angeordnet sein. Dadurch sind unterschiedliche Einsatzmöglichkeiten für die Bedienvorrichtung realisiert.

Ein nochmals weiterer Aspekt der Erfindung betrifft ein Verfahren zum Bedienen einer Bedienvorrichtung für ein Haushaltsgerät, bei welchem mittels einer Bedienoberfläche bei Bedienung durch einen Nutzer der Bedienvorrichtung zumindest eine Betriebsbedingung des Haushaltsgeräts eingestellt wird, wobei auf einer Unterseite der Bedienoberfläche eine kapazitive Erfassungseinrichtung zum kapazitiven Erfassen der Bedienung bereitgestellt wird, mittels welcher die Bedienung kapazitiv erfasst wird, wobei die Unterseite gegenüber einer Oberseite bereitgestellt wird, welche bei Bedienung dem Nutzer zugewandt ist und eine Außenseite der Bedienvorrichtung bildet, so dass die Erfassungseinrichtung als berührungssensitive Erfassungseinrichtung bereitgestellt wird, und die Bedienung des Nutzers durch eine Berührung der Oberseite durch den Nutzer auf Basis einer berührungsbasierten Kapazitätsänderung erfasst wird und zusätzlich die Bedienung des Nutzers durch ein von dem Nutzer bedientes Bedienelement der Bedienvorrichtung auf Basis einer berührungslosen Kapazitätsänderung durch das Bedienelement erfasst wird.

Vorteilhafte Ausgestaltungsformen der Bedienvorrichtung sind als vorteilhafte Ausgestaltungsformen des Haushaltsgeräts sowie des Verfahrens anzusehen. Die Bedienvorrichtung sowie das Haushaltsgerät weisen dazu gegenständliche Merkmale auf, welche die Durchführung des Verfahrens oder eine vorteilhafte Ausgestaltungsform davon ermöglichen.

Mit den Angaben "oben", "unten", "hinten", "horizontal", "vertikal", "Tiefenrichtung", "Breitenrichtung" , "Höhenrichtung" etc. sind bei bestimmungsgemäßem Gebrauch und bestimmungsgemäßem Anordnen der Bedienvorrichtung beziehungsweise des Haushaltsgeräts gegebene Positionen und Orientierungen angegeben.

Weitere Merkmale der Erfindung ergeben sich aus den Ansprüchen, den Figuren sowie der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen.

Ausführungsbeispiele der Erfindung werden nachfolgend anhand schematischer Zeichnungen näher erläutert.

Dabei zeigen:
- Fig. 1: eine schematische Perspektivansicht einer Ausführungsform eines Haushaltsgeräts;
- Fig. 2: eine schematische Explosionsdarstellung einer Ausführungsform einer Bedienvorrichtung;
- Fig. 3: eine nochmals weitere schematische Perspektivansicht einer Ausführungsform der Bedienvorrichtung;
- Fig. 4: eine nochmals weitere schematische Perspektivansicht einer Ausführungsform der Bedienvorrichtung;
- Fig. 5: eine nochmals weitere schematische Perspektivansicht einer Ausführungsform der Bedienvorrichtung;
- Fig. 6: eine schematische Ansicht einer Ausführungsform eines Bedienelements;
- Fig. 7: eine weitere schematische Ansicht einer Ausführungsform des Bedienelements gemäß Fig. 6; und
- Fig. 8: eine weitere schematische Ansicht des Bedienelements gemäß Fig. 6 und/oder 7 in einer weiteren Ansicht.

In den Figuren sind gleiche oder funktionsgleiche Elemente mit den gleichen Bezugszeichen versehen.

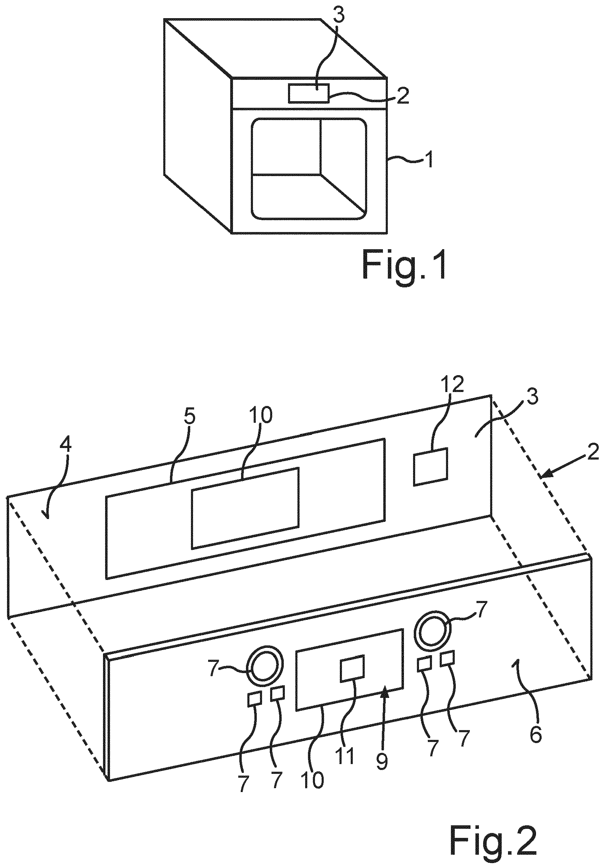

Fig. 1 zeigt in einer schematischen Perspektivansicht eine Ausführungsform eines Haushaltsgeräts 1. Das Haushaltsgerät 1 ist im vorliegenden Ausführungsbeispiel insbesondere als Gargerät ausgebildet. Insbesondere zeigt die Fig. 1, dass das Haushaltsgerät 1 als Backofen ausgebildet sein kann. Alternativ oder ergänzend kann das Haushaltsgerät 1 auch als Kochmulde, beispielsweise in einem Kombigerät, ausgebildet sein.

Das Haushaltsgerät 1 weist eine Bedienvorrichtung 2 auf. Insbesondere zeigt Fig. 1, dass die Bedienvorrichtung 2 eine Bedienoberfläche 3 aufweisen kann. Die Bedienoberfläche 3 ist bei bestimmungsgemäßem Gebrauch des Haushaltsgeräts 1 insbesondere horizontal und/oder vertikal des Haushaltsgeräts 1 angeordnet, vorliegend horizontal angeordnet.

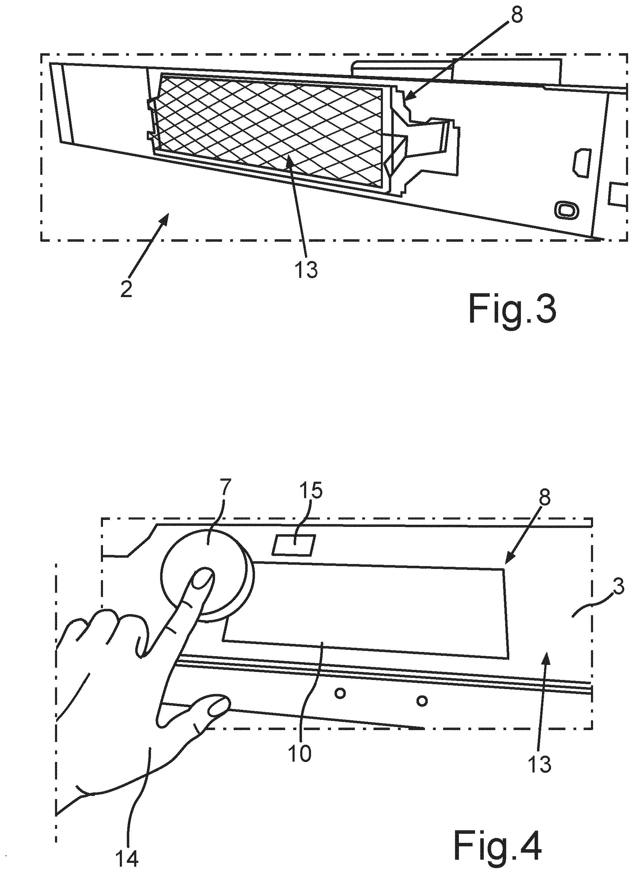

Fig. 2 zeigt in einer schematischen Explosionsdarstellung eine Ausführungsform der Bedienvorrichtung 2. Die Bedienvorrichtung 2 weist die Bedienoberfläche 3 auf, welche dazu ausgebildet ist, bei Bedienung durch einen nicht gezeigten Nutzer 14 (Fig. 4) der Bedienvorrichtung 2 zumindest eine Betriebsbedingung des Haushaltsgeräts 1 einzustellen, wobei auf einer Unterseite 4 der Bedienoberfläche 3 eine kapazitive Erfassungseinrichtung 5 zum kapazitiven Erfassen der Bedienung ausgebildet ist, wobei die Unterseite 4 einer Oberseite 6, welche bei Bedienung dem Nutzer 14 zugewandt ist und eine Außenseite der Bedienvorrichtung 2 bildet, ausgebildet ist. Es ist vorgesehen, dass die kapazitive Erfassungseinrichtung 5 als berührungssensitive Erfassungseinrichtung 5 ausgebildet ist und dazu ausgebildet ist, die Bedienung des Nutzers 14 durch eine Berührung der Oberseite 6 durch den Nutzer 14 auf Basis einer berührungsbasierten Kapazitätsänderung zu erfassen und zusätzlich dazu ausgebildet ist, die Bedienung des Nutzers 14 durch ein vom Nutzer 14 bedientes Bedienelement 7 der Bedienvorrichtung 2 auf der Bedienoberfläche 6 einer berührungslosen Kapazitätsänderung durch das Bedienelement 7 zu erfassen.

Dadurch ist es ermöglicht, dass somit auf zwei unterschiedliche Arten eine Bedienung erfolgen kann. Insbesondere durch beispielsweise einen Finger des Nutzers 14, kann eine Bedienung auf der berührungssensitiven Erfassungseinrichtung 5 berührungsbasiert durchgeführt werden. Alternativ oder ergänzend kann mittels des Bedienelements 7, welches auf der Bedienoberfläche 3 angeordnet werden kann, eine entsprechende Bedienung erfolgen. Dadurch ist es ermöglicht, dass hochfunktionell die Bedienvorrichtung 2 durch den Nutzer 14 bedient werden kann. Insbesondere kann damit der Nutzer 14 personalisiert entscheiden, ob dieser berührungsbasiert oder berührungslos mit dem Bedienelement 7 das Haushaltsgerät 1 bedienen möchte.

Insbesondere wird dadurch der Aufbau einer robusten Bedienvorrichtung 2 für die Verwendung in einem Haushaltsgerät 1 bei der Verwendung/Auswertung von kapazitiven Erfassungseinrichtungen 5, welche auch als Touch-Sensoren bezeichnet werden können, erreicht, bei welcher ein stabiler und definierter mechanischer Aufbau notwendig ist, da die Touch-Sensorik empfindlich auf Material- und/oder Abstandstoleranzen zwischen dem Sensor und dem Finger reagiert. Des Weiteren werden dadurch mechanische Toleranzen zwischen dem Sensor und dem Finger minimiert. Ferner kann dadurch variantenreduziert eine entsprechende Bedienvorrichtung 2 bereitgestellt werden. Insbesondere kann hierbei ein Blendendesign, beispielsweise eine Schalterfront des Haushaltsgeräts 1, das eine marken- und produktspezifische Ausprägung der Bedienvorrichtung 2, welche auch als User Interface bezeichnet werden kann, beziehungsweise der Bedienblende aufweist, ohne aufwendige Hardware-Änderungen ermöglicht werden. Ferner kann insbesondere vorgesehen sein, dass die Bedienelemente 7 sowohl auf der Bedienoberfläche 3, insbesondere sozusagen "on-screen", angeordnet sind, das heißt, die Bedienung erfolgt über beziehungsweise auf dem Display beziehungsweise auch außerhalb des Displays, sozusagen "off-screen" - das heißt Einzeltasten und Slider sind neben dem Display. Insbesondere ist somit vorgesehen, dass die Bedienoberfläche 3 auch eine Anzeigeeinrichtung 9 aufweisen kann, auf welcher entsprechende Symbole 11 beziehungsweise Eingabemöglichkeiten angezeigt werden können.

Als Bedienelement 7 können insbesondere mechanische Bedienelemente 7, wie zum Beispiel ein "rotary encoder", ein Programmwähler oder Tastenelemente, gewählt werden, welche insbesondere keine elektrischen Durchbrüche aufweisen. Dadurch kann eine hohe Flexibilität sowie eine hohe elektrische Robustheit, insbesondere gegenüber EMV (elektromagnetische Verträglichkeit), realisiert werden. Des Weiteren sind die Bedienelemente 7 entsprechend reinigungsfreundlich und verschleißfrei.

Im vorliegenden Ausführungsbeispiel sind auf der Bedienoberfläche 3, insbesondere auf der Oberseite 6, insbesondere sechs Bedienelemente 7 angeordnet. Insbesondere zeigt die Fig. 2, dass unterschiedliche Bedienelemente 7 an der Oberseite 6 angeordnet werden können. Insbesondere kann es sich dabei sowohl um sogenannte Drehschalter als auch Kippschalter beziehungsweise Tastenschalter handeln. Insbesondere kann es sich bei dem Bedienelement 7 auch um ein sogenanntes Twist-Pad handeln.

Ferner zeigt die Fig. 2 insbesondere, dass die kapazitive Erfassungseinrichtung 5 als Foliensensor 8 ausgebildet ist. Insbesondere kann vorgesehen sein, dass der Foliensensor 8 als zweidimensionaler Foliensensor direkt hinter der Bedienoberfläche 3 angeordnet ist. Insbesondere ist der Foliensensor 8 direkt auf der Bedienoberfläche 3 aufgeklebt, so dass der Foliensensor 8 fest mit der Bedienoberfläche 3 verbunden ist. Bei dem Foliensensor kann es sich um einen Foliensensor 8 handeln, welcher mit dem sogenannten Rolle-zu-Rolle-Verfahren hergestellt wurde.

Ferner zeigt die Fig. 2 insbesondere, dass die Bedienoberfläche 3 insbesondere aus Glas oder Polymethylmethacrylat ausgebildet ist. Insbesondere wird das Polymethylmethacrylat (PMMA) auch als Plexiglas bezeichnet. Insbesondere kann dadurch eine einfache und dennoch zuverlässige Bedienoberfläche 3 bereitgestellt werden.

Ferner kann insbesondere vorgesehen sein, dass die kapazitive Erfassungseinrichtung 5 dazu ausgebildet ist, eine Eigenkapazität und/oder eine Gegenkapazität zum Erfassen der Kapazitätsänderung zu erfassen. Mit anderen Worten ist die kapazitive Erfassungseinrichtung 5 sowohl "self-capacitance"-fähig als auch "mutual-capacitance"-fähig. Dadurch ist es auf unterschiedliche Arten und Weisen ermöglicht, eine Bedienung der Bedienvorrichtung 2 zu realisieren. Insbesondere ist es dadurch ermöglicht, dass zuverlässig eine Bedienung sowohl durch Berührung als auch berührungslos erfolgen kann. Insbesondere in der Gegenkapazitätserfassung lassen sich komplexe Bedienelemente 7 realisieren. Insbesondere können dadurch mit dem einen Bedienelement 7 unterschiedliche Funktionen innerhalb der Bedienvorrichtung 2 beziehungsweise innerhalb des Haushaltsgeräts 1 bedient werden. Eine elektrische Funktionalität des Bedienelements 7 ist dadurch insbesondere vor mechanischen Einflüssen weitgehend entkoppelt.

Ferner zeigt die Fig. 2 insbesondere, dass die berührungssensitive Erfassungseinrichtung 5 insbesondere auch als berührungssensitive Anzeigeeinrichtung 9 ausgebildet sein kann.

Hierzu kann insbesondere vorgesehen sein, dass die berührungssensitive Erfassungseinrichtung einen Anzeigebereich 10 aufweist. Insbesondere ist der Anzeigebereich 10 ebenfalls berührungssensitiv. Dadurch ist es ermöglicht, dass beispielsweise zumindest ein Symbol 11 auf dem Anzeigebereich 10 dargestellt werden kann. Durch Berühren des Symbols 11 kann beispielsweise die Betriebsbedingung eingestellt werden. Insbesondere kann dabei vorgesehen, dass der Foliensensor 8 größer ausgebildet ist als der Anzeigebereich 10. Insbesondere kann somit das Bedienelement 7 neben dem Anzeigebereich 10 bereitgestellt werden. Somit ist es ermöglicht, dass neben dem Anzeigebereich 10 auch durch die Bedienelemente 7 neben dem Anzeigebereich 10 eine entsprechende Bedienung der Bedienvorrichtung 2 durchgeführt werden kann.

Ferner kann vorgesehen sein, dass die Bedienvorrichtung 2 einen Mikrocontroller 12 aufweisen kann, welcher dazu ausgebildet ist, in Abhängigkeit von der erfassten Kapazitätsänderung ein Steuersignal zum Einstellen der Betriebsbedingung zu erzeugen. Insbesondere kann hierzu vorgesehen sein, dass der Mikrocontroller 12 dazu ausgebildet ist, bei einem Überschreiten eines vorgegebenen Kapazitätsänderungsschwellwerts der erfassten Kapazitätsänderung das Steuersignal zu erzeugen.

Bei einem Verfahren zum Bedienen der Bedienvorrichtung 2 für das Haushaltsgerät 1 wird mittels der Bedienoberfläche 3 bei Bedienung durch den Nutzer 14 der Bedienvorrichtung 2 zumindest die eine Betriebsbedingung des Haushaltsgeräts 1 eingestellt, wobei auf der Unterseite 4 der Bedienoberfläche 3 die kapazitive Erfassungseinrichtung 5 zum kapazitiven Erfassen der Bedienung bereitgestellt wird, mittels welcher die Bedienung kapazitiv erfasst wird, wobei die Unterseite 3 gegenüber der Oberseite 6 bereitgestellt wird, welche bei Bedienung dem Nutzer 14 zugewandt ist und eine Außenseite der Bedienvorrichtung 2 bildet, wobei die Erfassungseinrichtung 5 als berührungssensitive Erfassungseinrichtung 5 bereitgestellt wird und die Bedienung des Nutzers 14 durch eine Berührung der Oberseite 6 durch den Nutzer 14 auf Basis einer berührungslosen Kapazitätsänderung erfasst wird und zusätzlich die Bedienung des Nutzers 14 durch das von dem Nutzer 14 bedienten Bedienelement 7 der Bedienvorrichtung 2 auf Basis der berührungslosen Kapazitätsänderung durch das Bedienelement 7 erfasst wird.

Fig. 3 zeigt in einer schematischen Perspektivansicht eine Ausführungsform der Bedienvorrichtung 2. Insbesondere zeigt die Fig. 3 den Foliensensor 8. Der Foliensensor 8 ist im vorliegenden Ausführungsbeispiel insbesondere diamantartig ausgebildet. Mit anderen Worten weist der Foliensensor 8 eine diamantartige Struktur von Erfassungselementen 13 der kapazitiven Erfassungseinrichtung 5 auf. Durch die diamantartige Struktur kann insbesondere eine Eigenkapazitätsmessung durchgeführt werden. Die diamantartige Struktur kann insbesondere auch als Diamant-Pattern bezeichnet werden. Dadurch ist insbesondere eine sogenannte Mehrfingergesten-Erkennung ermöglicht. Mit anderen Worten können gleichzeitig verschiedene Eingaben ausgewertet werden.

Fig. 4 zeigt in einer weiteren schematischen Ansicht eine Ausführungsform der Bedienvorrichtung 2. Insbesondere zeigt Fig. 4, dass die Bedienvorrichtung 2 dazu ausgebildet ist, dass das Bedienelement 7 zerstörungsfrei auf der Bedienoberfläche 3 aufgesetzt und abgenommen werden kann. Insbesondere ist das Bedienelement 7 magnetisch ausgebildet, und das Bedienelement 7 kann mittels einer Magneteinrichtung 15 der Bedienvorrichtung 2 an der Bedienoberfläche 3 gehalten werden. Insbesondere zeigt die Fig. 4 ferner, dass das Bedienelement 7 dazu ausgebildet ist, frei beweglich auf der Bedienoberfläche 3 verschoben zu werden.

Ferner kann insbesondere vorgesehen sein, dass die kapazitive Erfassungseinrichtung 5 zum Erfassen einer relativen Position des Bedienelements 7 gegenüber der Bedienoberfläche 3 ausgebildet ist und in Abhängigkeit der erfassten Position die zumindest eine Betriebsbedingung eingestellt ist. Insbesondere kann dies in der Gegenkapazitätsmessung, insbesondere im Gegenkapazitätsmodus, der Bedienvorrichtung 2 durchgeführt werden. Hierzu kann das von der Erfassungseinrichtung 5 gemessene Intensitätspattern abhängig von Größe und Form der Elektroden 16 parallel zur Bedienoberfläche 3 gemessen werden, wodurch sich die absolute Position, insbesondere die absolute Winkelposition, des Bedienelements 7 feststellen lässt. In Abhängigkeit davon kann dann wiederum die Betriebsbedingung des Haushaltsgeräts 1 eingestellt werden.

Ferner zeigt die Fig. 4, dass die kapazitive Erfassungseinrichtung 5 zum Erfassen einer Mehrfingergesten-Erkennung ausgebildet ist. Mit anderen Worten ist die Bedienoberfläche 3 Multi-Touch-fähig ausgebildet. Hierzu kann insbesondere die Bedienvorrichtung 2 im Gegenkapazitätsmodus ausgebildet sein. Durch Berührung beziehungsweise Bedienung des Bedienelements 7 wird ein entsprechendes Intensitätspattern erzeugt, das von dem Mikrocontroller 12 ausgewertet und in eine entsprechende Bedienoperation umgesetzt werden kann.

Ferner zeigt die Fig. 4 insbesondere, dass die Bedienoberfläche 3 durchbruchslos ausgebildet ist. Mit anderen Worten weist die Bedienoberfläche 3 keine Durchbrüche auf, so dass insbesondere die Elektronik hinter der Bedienoberfläche 3 vor Witterungsbedingungen geschützt ist.

Insbesondere kann ferner vorgesehen sein, dass die kapazitive Erfassungseinrichtung 5 zum gleichzeitigen Erfassen der berührungsbasierten Kapazitätsänderung und der berührungslosen Kapazitätsänderung ausgebildet ist. Mit anderen Worten kann eine hybride Bedienung durchgeführt werden. Insbesondere können somit sowohl die Bedienung mittels des Bedienelements 7 als auch durch die Berührung des Nutzers 14 auf dem Anzeigebereich 10 realisiert werden.

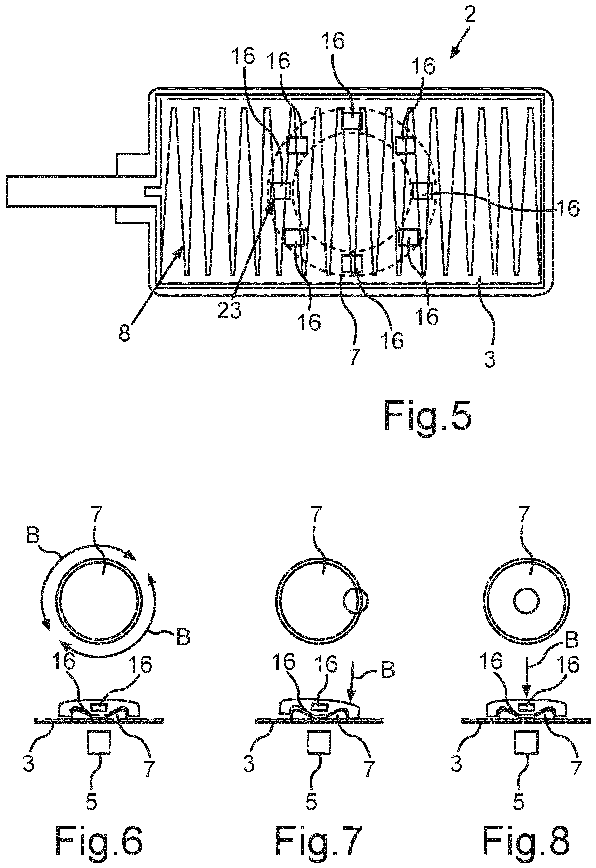

Fig. 5 zeigt in einer weiteren schematischen Ansicht eine Ausführungsform der Bedienvorrichtung 2. Insbesondere zeigt die Fig. 5 die Bedienoberfläche 3. Insbesondere zeigt Fig. 5, dass der Foliensensor 8 eine Vielzahl von nebeneinander liegenden Erfassungselementen 13 aufweist, welche mittels der kapazitiven Erfassungseinrichtung 5 unabhängig voneinander ausgewertet ist. Insbesondere zeigt die Fig. 5, dass der Foliensensor 8 mit einer sogenannten Backgammon-Struktur ausgebildet sein kann. Insbesondere bei der sogenannten Backgammon-Struktur handelt es sich um eine Struktur des Foliensensors 8, welche einem Backgammon-Brett entspricht. Insbesondere kann dadurch eine Eigenkapazität zuverlässig erfasst werden. Dadurch kann geometrieabhängig die Bedienoberfläche 3 in logische Bereiche eingeteilt werden, so dass unabhängig voneinander diese logischen Bereiche ausgewertet werden können. Ferner zeigt die Fig. 5 gestrichelt das Bedienelement 7, welches eine Vielzahl von Elektroden 16 aufweisen kann. In Abhängigkeit der jeweiligen Elektroden 16, insbesondere in Abhängigkeit der jeweiligen Position der Elektroden 16 kann dadurch eine entsprechende Auswertung des Steuersignals durchgeführt werden.

Fig. 6 bis 8 zeigen ein Bedienelement 7 in unterschiedlichen Varianten beziehungsweise in unterschiedlichen Stellungen, wobei die unterschiedlichen Stellungen durch unterschiedliche Bewegungen B ausgeführt sind. Die unterschiedlichen Bewegungen B der Fig. 6 bis 8 können sowohl einzeln als auch gemeinsam durchgeführt werden, wobei dadurch auch unterschiedliche Betriebsbedingungen eingestellt werden können. Insbesondere zeigt Fig. 6, dass das Bedienelement 7 beispielsweise gedreht werden kann, wodurch eine entsprechende Bedienung beziehungsweise eine Betriebseinstellung eingestellt werden kann. Fig. 7 zeigt, dass durch beispielsweise eine Berührung in einem Seitenbereich des Bedienelements 7 ein Kippen des Bedienelements 7 durchgeführt werden kann, wodurch ebenfalls eine Betriebsbedingung des Haushaltsgeräts 3 eingestellt werden kann. Fig. 8 zeigt, dass durch ein Drücken mittig des Bedienelements 7 ebenfalls eine Betriebsbedingung eingestellt werden kann. Insbesondere kann beispielsweise dadurch eine Push-Bewegung realisiert werden.

Insbesondere kann somit vorgesehen sein, dass die kapazitive Erfassungseinrichtung 5 zum Erfassen einer relativen Stellung des Bedienelements 7 gegenüber der Bedienoberfläche 3 ausgebildet ist, und in Abhängigkeit von der erfassten Stellung zumindest eine Betriebsbedingung eingestellt ist. Ferner kann vorgesehen sein, dass das Bedienelement 7 eine Vielzahl von den Elektroden 16 aufweist, welche mit der kapazitiven Erfassungseinrichtung 5 wechselwirken und auf Basis dieser Wechselwirkung die berührungslose Bedienung erfasst ist.

Insgesamt zeigen die Fig. 1 bis 8 ein adaptives User-Interface.

### Bezugszeichenliste

- 1: Haushaltsgerät
- 2: Bedienvorrichtung
- 3: Bedienoberfläche
- 4: Unterseite
- 5: kapazitive Erfassungseinrichtung
- 6: Oberseite
- 7: Bedienelement
- 8: Foliensensor
- 9: Anzeigeeinrichtung
- 10: Anzeigebereich
- 11: Symbol
- 12: Mikrocontroller
- 13: Erfassungselement
- 14: Nutzer
- 15: Magneteinrichtung
- 16: Elektrode
- B: Bewegung

## Patentansprüche

1. Bedienvorrichtung (2) für ein Haushaltsgerät (1), mit einer Bedienoberfläche (3), welche dazu ausgebildet ist, bei Bedienung durch einen Nutzer (14) der Bedienvorrichtung (2) zumindest eine Betriebsbedingung des Haushaltsgeräts (1) einzustellen, wobei auf einer Unterseite (4) der Bedienoberfläche (3) eine kapazitive Erfassungseinrichtung (5) zum kapazitiven Erfassen der Bedienung ausgebildet ist, wobei die Unterseite (4) gegenüber einer Oberseite (6), welche bei Bedienung dem Nutzer (14) zugewandt ist und eine Außenseite der Bedienvorrichtung (2) bildet, ausgebildet ist, wobei die kapazitive Erfassungseinrichtung (5) als berührungssensitive Erfassungseinrichtung (5) ausgebildet ist und dazu ausgebildet ist, die Bedienung des Nutzers (14) durch eine Berührung der Oberseite (3) durch den Nutzer (14) auf Basis einer berührungsbasierten Kapazitätsänderung zu erfassen und zusätzlich dazu ausgebildet ist, die Bedienung des Nutzers (14) durch ein von dem Nutzer (14) bedientes Bedienelement (7) der Bedienvorrichtung (2) auf der Bedienoberfläche (3) auf Basis einer berührungslosen Kapazitätsänderung durch das Bedienelement (7) zu erfassen,
wobei die kapazitive Erfassungseinrichtung (5) als Foliensensor (8) ausgebildet ist, wobei der Foliensensor (8) eine diamantartige Struktur nämlich Diamant-Pattern von Erfassungselementen (13) der kapazitiven Erfassungseinrichtung (5) zum Erfassen einer Selbstkapazität sowie einer Gegenkapazität, dergestalt dass eine Mehrfingergestenerkennung bereitstellbar ist, um gleichzeitig verschiedene Eingaben auszuwerten, aufweist,
und wobei der Foliensensor (8) eine Vielzahl von nebeneinanderliegenden Erfassungselementen (13) aufweist, welche mittels der kapazitiven Erfassungseinrichtung (5) unabhängig voneinander ausgewertet sind, und
wobei die berührungssensitive Erfassungseinrichtung (5) als berührungssensitive Anzeigeeinrichtung (9) ausgebildet ist und zum Anzeigen zumindest eines Symbols (11) und zum Erfassen der Berührung ausgebildet ist, und wobei das Bedienelement (7) dazu ausgebildet ist, zerstörungsfrei auf der Bedienoberfläche (3) aufgesetzt und abgenommen zu werden und/oder das Bedienelement (7) dazu ausgebildet ist, frei beweglich auf der Bedienoberfläche (3) verschoben zu werden und/oder die Bedienoberfläche (3) durchbruchslos ausgebildet ist, und
wobei die kapazitive Erfassungseinrichtung (5) zum Erfassen einer Mehrfingergestenerkennung ausgebildet ist.

2. Bedienvorrichtung nach einem der vorhergehenden Ansprüche, **dadurch gekennzeichnet, dass** das Bedienelement (7) magnetisch ausgebildet ist und das Bedienelement (7) mittels einer Magneteinrichtung (15) der Bedienvorrichtung (2) an der Bedienoberfläche (3) gehalten ist.

3. Bedienvorrichtung (2) nach einem der vorhergehenden Ansprüche, **dadurch gekennzeichnet, dass** die kapazitive Erfassungseinrichtung (5) dazu ausgebildet ist, eine Eigenkapazität und/oder eine Gegenkapazität zum Erfassen der Kapazitätsänderung zu erfassen.

4. Bedienvorrichtung (2) nach einem der vorhergehenden Ansprüche, **dadurch gekennzeichnet, dass** die kapazitive Erfassungseinrichtung (5) zum Erfassen einer relativen Position des Bedienelements (7) gegenüber der Bedienoberfläche (3) ausgebildet ist, und in Abhängigkeit der erfassten Position die zumindest eine Betriebsbedingung eingestellt ist und/oder die kapazitive Erfassungseinrichtung (5) zum Erfassen einer relativen Stellung des Bedienelements (7) gegenüber der Bedienoberfläche (3) ausgebildet ist, und in Abhängigkeit der erfassten Stellung die zumindest eine Betriebsbedingung eingestellt ist.

5. Bedienvorrichtung (2) nach einem der vorhergehenden Ansprüche, **dadurch gekennzeichnet, dass** das Bedienelement (7) eine Vielzahl von Elektroden (13) aufweist, welche mit der kapazitiven Erfassungseinrichtung (5) wechselwirken und auf Basis dieser Wechselwirkung die berührungslose Bedienung erfasst ist.

6. Bedienvorrichtung (2) nach einem der vorhergehenden Ansprüche, **dadurch gekennzeichnet, dass** die kapazitive Erfassungseinrichtung (5) zum gleichzeitigen Erfassen der berührungsbasierten Kapazitätsänderung und der berührungslosen Kapazitätsänderung ausgebildet ist.

7. Haushaltsgerät (1) mit einer Bedienvorrichtung (2) nach einem der Ansprüche 1 bis 6, wobei das Haushaltsgerät (1) insbesondere ein Gargerät ist.

8. Haushaltsgerät (1) nach Anspruch 7, **dadurch gekennzeichnet, dass** die Bedienoberfläche (3) bei einem bestimmungsgemäßen Gebrauch des Haushaltsgeräts (1) horizontal und/oder vertikal an dem Haushaltsgerät (1) angeordnet ist.

9. Verfahren zum Bedienen einer Bedienvorrichtung (2) gemäß einem der vorhergehenden Ansprüche 1 bis 6, bei welchem mittels der Bedienoberfläche (3) bei Bedienung durch den Nutzer (14) der Bedienvorrichtung (2) zumindest eine Betriebsbedingung des Haushaltsgeräts (1) eingestellt wird, wobei Bedienung des Nutzers (14) durch eine Berührung der Oberseite (6) durch den Nutzer (14) auf Basis einer berührungsbasierten Kapazitätsänderung erfasst wird und zusätzlich die Bedienung des Nutzers (14) durch das von dem Nutzer (14) bediente Bedienelement (7) der Bedienvorrichtung (2) auf Basis einer berührungslosen Kapazitätsänderung durch das Bedienelement (7) erfasst wird.

## Claims

1. Control device (2) for a household appliance (1), with a user interface (3), which is embodied to set at least one operating condition of the household appliance (1) when the control device (2) is controlled by a user (14), wherein a capacitive detection facility (5) for capacitively detecting the control is embodied on a lower side (4) of the user interface (3), wherein the lower side (4) is embodied opposite an upper side (6), which faces the user (14) during control and forms an exterior side of the control device (2), wherein the capacitive detection facility (5) is embodied as a touch-sensitive detection facility (5) and is embodied to detect the control of the user (14) by the user (14) touching the upper side (3) on the basis of a touch-based change in capacitance and is additionally embodied to detect the control of the user (14) by a control element (7), of the control device (2), controlled by the user (14) on the user interface (3) on the basis of a contactless change in capacitance by the control element (7),
wherein the capacitive detection facility (5) is embodied as a foil sensor (8), wherein the foil sensor (8) has a diamond-type structure, namely diamond pattern of detection elements (13) of the capacitive detection facility (5) for detecting a self-capacitance and a counter capacitance, such that a multi finger gesture recognition can be provided in order to evaluate different inputs at the same time,
and wherein the foil sensor (8) has a plurality of detection elements (13) arranged adjacent to one another, which are evaluated independently of one another by means of the capacitive detection facility (5), and
wherein the touch-sensitive detection facility (5) is embodied as a touch-sensitive display facility (9), and is embodied to display at least one symbol (11) and to detect the contact, and wherein the control element (7) is embodied to be positioned on and removed from the user interface (3) in a non-destructive manner and/or the control element (7) is embodied to be moved in a freely movable manner on the user interface (3) and/or the user interface (3) is embodied to be recess-free, and
wherein the capacitive detection facility (5) is embodied to detect a multi finger gesture recognition.

2. Control device according to one of the preceding claims, **characterised in that** the control element (7) is embodied to be magnetic and the control element (7) is held on the user interface (3) by means of a magnet facility (15) of the control device (2).

3. Control device (2) according to one of the preceding claims, **characterised in that** the capacitive detection facility (5) is embodied to detect a self-capacitance and/or a counter capacitance in order to detect the change in capacitance.

4. Control device (2) according to one of the preceding claims, **characterised in that** the capacitive detection facility (5) is embodied to detect a relative position of the control element (7) with respect to the user interface (3), and as a function of the detected position the at least one operating condition is set and/or the capacitive detection facility (5) is embodied to detect a relative position of the control element (7) with respect to the user interface (3) and the at least one operating condition is set as a function of the detected position.

5. Control device (2) according to one of the preceding claims, **characterised in that** the control element (7) has a plurality of electrodes (13), which interact with the capacitive detection facility (5) and the contactless control is detected on the basis of this interaction.

6. Control device (2) according to one of the preceding claims, **characterised in that** the capacitive detection facilty (5) is embodied to simultaneously detect the touch-based change in capacitance and the contactless change in capacitance.

7. Household appliance (1) with a control device (2) according to one of claims 1 to 6, wherein the household appliance (1) is in particular a cooking appliance.

8. Household appliance (1) according to claim 7, **characterised in that** the user interface (3) is arranged horizontally and/or vertically on the household appliance (1) when the household appliance (1) is used as intended.

9. Method for controlling a control device (2) according to one of the preceding claims 1 to 6, in which by means of the user interface (3), at least one operating condition of the household appliance (1) is set when the control device (2) is controlled by the user (14), wherein the control of the user (14) is detected by the user (14) contacting the upper side (6) on the basis of a touch-based changed in capacitance and in addition the control of the user (14) by the control element (7) of the control device (2) controlled by the user (14) is detected by the control element (7) on the basis of a contactless change in capacitance.

## Revendications

1. Dispositif de commande (2) pour un appareil électroménager (1), comprenant une surface de commande (3), qui est configurée pour, lors d'une commande du dispositif de commande (2) par un utilisateur (14), régler au moins une condition de fonctionnement de l'appareil électroménager (1), dans lequel un dispositif de détection capacitif (5) permettant de détecter la commande est formé sur une face inférieure (4) de la surface de commande (3),
dans lequel la face inférieure (4) est formée en face d'une face supérieure (6), qui est orientée vers l'utilisateur (14) pour une commande et forme une face extérieure du dispositif de commande (2),
dans lequel le dispositif de détection capacitif (5) est configuré sous forme d'un dispositif de détection sensible au toucher (5) et est conçu pour détecter la commande de l'utilisateur (14) par un contact de la face supérieure (3) par l'utilisateur (14) sur la base d'une variation de capacité basée sur le contact et est conçu en outre pour détecter la commande de l'utilisateur (14) par l'intermédiaire d'un élément de commande (7) du dispositif de commande (2) commandé par l'utilisateur (14) sur la surface de commande (3) sur la base d'une variation de capacité sans contact par l'intermédiaire de l'élément de commande (7), dans lequel le dispositif de détection capacitif (5) est conçu sous forme d'un capteur en forme de feuille (8), le capteur en forme de feuille (8) présente une structure de type diamant, précisément un motif en diamant d'éléments de détection (13) du dispositif de détection capacitif (5) permettant de détecter une auto-capacité ainsi qu'une capacité mutuelle, de sorte qu'une détection de geste à plusieurs doigts peut être produite, afin d'évaluer simultanément plusieurs entrées, et
dans lequel le capteur en forme de feuille (8) comprend une pluralité d'éléments de détection adjacents (13), qui sont évalués indépendamment l'un de l'autre au moyen du dispositif de détection capacitif (5), et
dans lequel le dispositif de détection sensible au toucher (5) est conçu sous forme d'un dispositif d'affichage tactile (9) et est configuré pour afficher au moins un symbole (11) et pour détecter le toucher, et dans lequel l'élément de commande (7) est configuré pour être posé et enlevé sans engendrer de destruction sur la surface de commande (3) et/ou l'élément de commande (7) est configuré pour être déplacé de façon librement mobile sur la surface de commande (3) et/ou la surface de commande (3) est formée sans rupture, et dans lequel le dispositif de détection capacitif (5) est configuré pour détecter une reconnaissance de geste à plusieurs doigts.

2. Dispositif de commande (2) selon l'une des revendications précédentes, **caractérisé en ce que** l'élément de commande (7) est formé de façon magnétique et l'élément de commande (7) est maintenu contre la surface de commande (3) au moyen d'un organe d'aimant (15) du dispositif de commande (2).

3. Dispositif de commande (2) selon l'une des revendications précédentes, **caractérisé en ce que** le dispositif de détection capacitif (5) est configuré de façon à détecter une capacité propre et/ou une capacité mutuelle afin de détecter la variation de capacité.

4. Dispositif de commande (2) selon l'une des revendications précédentes, **caractérisé en ce que** le dispositif de détection capacitif (5) est configuré pour détecter une position relative de l'élément de commande (7) par rapport à la surface de commande (3), et l'au moins une condition de fonctionnement est réglée en fonction de la position détectée et/ou le dispositif de détection capacitif (5) est configuré pour détecter une disposition relative de l'élément de commande (7) par rapport à la surface de commande (3), et l'au moins une condition de fonctionnement est réglée en fonction de la disposition détectée.

5. Dispositif de commande (2) selon l'une des revendications précédentes, **caractérisé en ce que** l'élément de commande (7) comprend une pluralité d'électrodes (13), qui interagissent avec le dispositif de détection capacitif (5) et la commande sans contact est détectée sur la base de cette interaction.

6. Dispositif de commande (2) selon l'une des revendications précédentes, **caractérisé en ce que** le dispositif de détection capacitif (5) est configuré pour détecter simultanément la variation de capacité basée sur le toucher et la variation de capacité sans contact.

7. Appareil électroménager (1) comprenant un dispositif de commande (2) selon l'une des revendications 1 à 6, dans lequel l'appareil électroménager (1) est en particulier un appareil de cuisson.

8. Appareil électroménager (1) selon la revendication 7, **caractérisé en ce que** la surface de commande (3) est disposée horizontalement et/ou verticalement sur l'appareil électroménager pour une utilisation conforme de l'appareil électroménager (1).

9. Procédé de commande d'un dispositif de commande (2) selon l'une des revendications 1 à 6, dans lequel au moins une condition de fonctionnement de l'appareil électroménager (1) est réglée au moyen de la surface de commande (3) lors d'une commande par l'utilisateur (14) du dispositif de commande (2),
dans lequel la commande de l'utilisateur (14) est détectée par un toucher de la face supérieure (6) par l'utilisateur (14) sur la base d'une variation de capacité basée sur le contact et en outre la commande de l'utilisateur (14) est détectée par l'élément de commande (7) du dispositif de commande (2) commandé par l'utilisateur (14) sur la base d'une variation de capacité sans contact à travers l'élément de commande (7).
